# EUROPEAN PATENT SPECIFICATION

(11) **EP 2 402 775 B1**
(45) Date of publication and mention of the grant of the patent: **26.12.2018**
(21) Application number: 09840688.7
(22) Date of filing: 26.02.2009
(51) Int. Cl.: G01R 31/14, G01R 31/34

(54) **INSULATION INSPECTION/DIAGNOSIS DEVICE AND METHOD OF DYNAMO-ELECTRIC MACHINE**
EINRICHTUNG ZUR ISOLATIONSUNTERSUCHUNG/-DIAGNOSE UND VERFAHREN EINER DYNAMOELEKTRISCHEN MASCHINE
DISPOSITIF ET PROCÉDÉ DE CONTRÔLE / DIAGNOSTIC D'ISOLATION POUR MACHINE DYNAMO-ÉLECTRIQUE

(43) Date of publication of application: 04.01.2012
(73) Proprietor: Hitachi, Ltd., Chiyoda-ku Tokyo 100-8280 (JP)
(72) Inventor: OBATA, Koji, Hitachi-shi Ibaraki 319-1292 (JP)
(74) Representative: Beetz & Partner mbB
(86) International application number: PCT/JP2009/000842
(87) International publication number: WO 2010/097833

(56) References cited:
- GB-A- 516 710
- JP-A- 2004 045 307
- JP-A- 2007 232 517
- JP-A- 2007 232 517
- US-A1- 2006 022 679

## Description

### Technical Field

The present invention relates to an insulation inspection/diagnosis method of an electric rotating machine using a test voltage (inspection voltage) formed of any one of an impulse voltage, a rectangular wave voltage, a high frequency sine wave voltage, and a high frequency damped oscillatory wave voltage. In particular, the present invention relates to a partial discharge inspection/diagnosis method of an inverter-driven electric rotating machine using a test voltage.

### Background Art

In recent years, in terms of energy saving, variable-speed operation of an electric rotating machine using an inverter has been actively performed. However, it has been reported that, when an electric rotating machine is driven by using an inverter, various problems occur in association with the insulation of the electric rotating machine (see, e.g., Non-Patent Document 1). Specifically, it has been reported that, when a steeply rising voltage (inverter surge voltage) resulting from an ON/OFF operation of a switching element within the inverter propagates along a cable and reaches a terminal of the electric rotating machine, the inverter surge voltage jumps to double magnitude of original magnitude thereof at the terminal of the electric rotating machine due to a surge impedance mismatch between the cable and the electric rotating machine. It has also been reported that, when the steeply rising inverter surge voltage enters an interior of the electric rotating machine, a voltage is generated at a leadwire exit-side coil of the electric rotating machine. Accordingly, for an electric rotating machine to be inverter-driven, it is necessary to perform the insulation design of the electric rotating machine such that the electric rotating machine can withstand an inverter surge voltage, and also inspect whether or not the produced electric rotating machine has a predetermined dielectric strength. In addition, in a regular diagnosis after product shipment and after the initiation of operation, it is necessary to diagnose how insulation deterioration has advanced in association with the inverter surge.

As one of inspection/diagnosis methods of inverter-driven electric rotating machines, an insulation inspection/diagnosis method using an impulse voltage is known (e.g., Non-Patent Documents 2 to 4). For example, in Non-Patent Document 2, an impulse voltage having the same voltage rise time as that of an inverter surge voltage is applied to an electric rotating machine to measure whether or not partial discharge occurs at a predetermined voltage or measure a partial discharge start voltage at which partial discharge begins to occur when the voltage is boosted. Specifically, when it is assumed that, in driving the electric rotating machine using an inverter, an inverter surge voltage having a voltage rise time of 0.10 µs and a peak voltage of 1200 V is applied to the electric rotating machine, an impulse voltage having a voltage rise time of 0.10 µs and a peak voltage of 1200 V (× Safety Factor) is applied to the electric rotating machine to measure partial discharge in accordance with the method of Non-Patent Document 3. If partial discharge does not occur, the electric rotating machine is determined to be acceptable. Otherwise, on the conditions of boosting the impulse voltage from 0 V and measuring a voltage at that point in time when partial discharge starts, if the measured voltage is higher than the inverter surge voltage of 1200 V (× Safety Factor), the electric rotating machine is determined to be acceptable. On the other hand, in Non-Patent Document 4, an impulse voltage having the same rise time as that of an inverter surge voltage is applied to an electric rotating machine to inspect/diagnose whether or not a coil of the electric rotating machine dielectrically breaks down.

Non-Patent Document 1: Technical Report of the Institute of Electrical Engineers of Japan, No. 739, pp. 12 to 20
Non-Patent Document 2: IEC 60034-18-41
Non-Patent Document 3: IEC 61934
Non-Patent Document 4: IEC 60034-15
Patent Document 1: JP 2007 232517 A

Patent Document 1 (JP 2007 232517 A) discloses an insulation evaluation method for an inverter-driven motor. A test voltage, which is a bipolar alternate pulse voltage having a peak voltage Vm developed between the winding turns of the inverter-driven motor, a pulse width tw, and a frequency fp, is applied to an insulating sample to measure a lifetime tp until the insulating sample experiences dielectric breakdown. The relationship between the peak voltage Vm and the lifetime tp is acquired as the insulating life characteristics of the insulating sample and on the basis of the acquired insulating life characteristics, the insulating performance of the insulating sample is evaluated. This method is not suitable for testing delivered motors before use, since it is destructive.

### Disclosure of Invention

### Problem to be Solved by Invention

On this occasion, an inverter-driven electric rotating machine was inspected/diagnosed by using the partial discharge inspection/diagnosis method among the foregoing methods. In the examined target electric rotatingmachine, an inverter surge voltage with 0.10 µs was assumed to be applied, so that an impulse power supply having a voltage rise time of 0.10 µs was connected to the electric rotating machine, and a partial discharge start voltage was measured. The measured partial discharge start voltage was compared with an estimated value of the partial discharge start voltage determined in advance from the characteristics of an enameled wire used for production of the electric rotating machine and a voltage distribution inside the electric rotating machine.

However, the partial discharge start voltage of the electric rotating machine measured in accordance with the conventional method was higher than the estimated value. To study such a cause, as a result of checking for an output voltage waveform of the impulse power supply when the electric rotating machine is connected to the impulse power supply, it became evident that the rise time of the impulse voltage was increased to 0.25 µs. Accordingly then, the estimated value of the partial discharge start voltage of the electric rotating machine was determined again from a voltage resulting from voltage sharing among windings when an inverter surge voltage having a voltage rise time of 0.25 µs was applied and from the partial discharge start voltage of the enameled wire used for the windings. The determined-estimated value of the partial discharge start voltage is compared with the partial discharge start voltage of the electric rotating machine determined through the use of the impulse voltage previously mentioned. However, even though calculation was performed using the inter-winding shared voltage when the inverter surge voltage with 0.25 µs was applied, the partial discharge start voltage of the electric rotating machine determined through the use of the impulse voltage was higher than the estimated value.

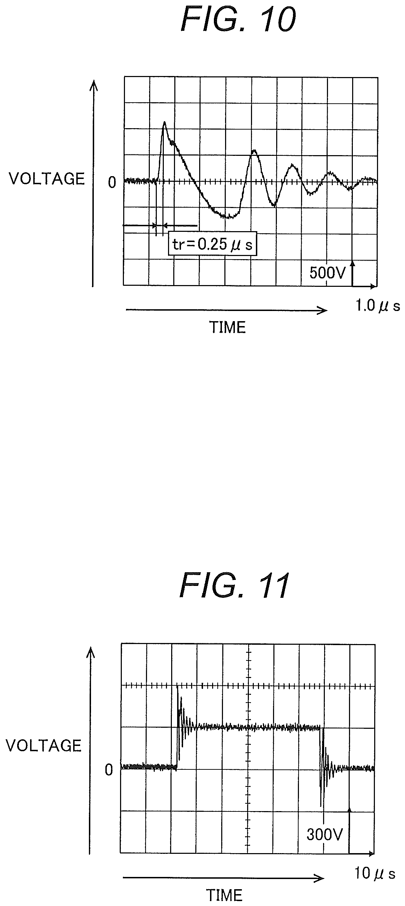

Thus, it was found that, by merely preparing the impulse power supply having the same rise time as that of the inverter surge voltage applied to the electric rotating machine when it is inverter-driven, applying the impulse voltage to the electric rotating machine, and measuring the resulting partial discharge start voltage, the partial discharge characteristic of the electric rotating machine might not be able to be correctly measured. A conceivable reason for this may be that, in an electric rotating machine such as a motor having a large electrostatic capacitance, the rising of the impulse voltage is slow, the original voltage waveforms of the inverter surge voltage and the impulse test voltage are greatly different from each other, or the like (the details thereof are described in Embodiment 1 using FIG. 10).

It is the object of the present invention to provide a method of an insulation inspection/diagnosis of an electric rotating machine, particularly with a partial discharge inspection/diagnosis thereof, which performs a correct inspection/diagnosis of the insulation characteristic of the electric rotating machine.

This object is accomplished with an inspection/diagnosis method with the features of claim 1.

Dependent claims are directed on features of preferred embodiments of the invention.

### Means for Solving Problem

The object of the present invention is attained by the following method. That is, firstly, an electric rotating machine provided with a terminal for measuring a voltage distribution inside a winding is prepared, and an inverter surge voltage or a voltage waveform simulating the inverter surge voltage is applied thereto to measure voltage distributions between windings and between different phases inside the electric rotating machine. Secondly, a test voltage power supply for generating a test voltage formed of any one of an impulse voltage (unipolar or bipolar impulse voltage), a rectangular wave voltage, a high frequency sine wave voltage, and a high frequency damped oscillatory wave voltage and used for an inspection/diagnosis test of the electric rotating machine is prepared, and the test voltage is applied to the electric rotating machine used for voltage distribution measurement to measure the voltage distributions between the windings and between the different phases inside the electric rotating machine. Thirdly, a ratio between a shared voltage inside the electric rotating machine measured firstly and a shared voltage inside the electric rotating machine measured secondly is calculated and designated as a correction factor for the test voltage, which is stored in an inspection/diagnosis device. Fourthly, using the test voltage formed of any one of the impulse voltage, the rectangular wave voltage, the high frequency sine wave voltage, and the high frequency damped oscillatory wave voltage, the insulation characteristic of the electric rotating machine is measured.

That is, the test voltage having a peak voltage (or peak-to-peak voltage) obtained by correcting the peak voltage (or peak-to-peak voltage) of the inverter surge voltage through multiplication by the foregoing correction factor is acquired and, by applying the test voltage, the insulation characteristic (e.g., the presence or absence of the occurrence of partial discharge or whether or not dielectric breakdown occurs) is measured. Alternatively, the test voltage such as the impulse voltage is boosted from 0 V to a desired voltage, and the insulation characteristic (partial discharge start voltage or dielectric breakdown voltage) ismeasured. Fifthly, when the electric rotating machine is inspected using the test voltage, the peak voltage (or peak-to-peak voltage) of the test voltage actually applied to the electric rotating machine is divided by the correction factor obtained thirdly, and converted to a peak voltage (or peak-to-peak voltage) equivalent to the actual inverter surge voltage. Sixthly, the object of the present invention can be attained by a method of displaying the peak voltage (or peak-to-peak voltage) equivalent to the inverter surge voltage, together with the insulation characteristic, on a display unit, and notifying a user whether the product is acceptable or non-acceptable.

### Effect of invention

In the present invention, the voltage distribution inside the electric rotating machine when it is inverter-driven is compared with the voltage distribution inside the electric rotating machine during an impulse test to correct the test voltage. Therefore, in the insulation inspection/diagnosis of the electric rotating machine using the impulse voltage, particularly in the partial discharge inspection/diagnosis thereof, the insulation characteristic of the electric rotating machine can be correctly inspected/diagnosed.

### Brief Description of the Drawings

[FIG. 1] A partial discharge inspection/diagnosis device for an electric rotating machine according to Embodiment 1 of the present invention, which has functions of measuring voltage distributions inside the electric rotating machine when an inverter surge voltage and an impulse voltage are applied to the electric rotating machine, and correcting a test voltage (which checks the presence or absence of partial discharge at a predetermined voltage).
[FIG. 2] A partial discharge inspection/diagnosis device for an electric rotating machine according to Embodiment 3 of the present invention, which additionally measures voltage distributions inside the electric rotating machine when an inverter surge voltage and an impulse voltage are applied to the electric rotating machine, and manually inputs a voltage correction factor and the inverter surge voltage (which checks the presence or absence of partial discharge at a predetermined voltage).
[FIG. 3] A partial discharge inspection/diagnosis device for an electric rotating machine according to Embodiment 4 of the present invention, which additionally measures voltage distributions inside the electric rotating machine when an inverter surge voltage and an impulse voltage are applied to the electric rotating machine, and manually inputs a voltage correction factor and a test voltage (which checks the presence or absence of partial discharge at a predetermined voltage).
[FIG. 4] A partial discharge inspection/diagnosis device for an electric rotating machine according to Embodiment 5 of the present invention, which has a function of specifying a coil in which partial discharge has occurred, by using voltage distributions inside the electric rotating machine and a directional antenna.
[FIG. 5] A graph showing a voltage distribution between winding turns inside the electric rotating machine when the inverter surge voltage and the impulse voltage are applied to the electric rotating machine.
[FIG. 6] A graph showing a voltage distribution between different phases inside the electric rotating machine when the inverter surge voltage and the impulse voltage are applied to the electric rotating machine.
[FIG. 7] An illustrative view of determining voltage distributions inside the electric rotating machine when the inverter surge voltage and the impulse voltage are applied to the electric rotating machine and a conversion factor using a partial discharge inspection/diagnosis device 201 and another calculating device.
[FIG. 8] A conventional partial discharge inspection/diagnosis device for an electric rotating machine using an impulse voltage .
[FIG. 9] An illustrative view showing a voltage rising portion of an inverter surge voltage.
[FIG. 10] An illustrative view showing a voltage rising portion of an impulse voltage waveform.
[FIG. 11] An illustrative view showing the entire inverter surge voltage.
[FIG. 12] A partial discharge inspection/diagnosis device of an electric rotating machine according to Embodiment 2 of the present invention, which has functions of measuring voltage distributions inside the electric rotating machine when an inverter surge voltage and an impulse voltage are applied to the electric rotating machine, and correcting a test voltage (which measures a partial discharge start voltage).

### Description of Numerals

2: Input Unit, 4: 3-Phase Voltage Application Switch, 5: Voltage Waveform Measuring Unit, 3: Simulated Inverter Surge Voltage Power Supply (Arbitrary Waveform Generator), 6: Voltage Distribution Calculating/Recording Unit, 7: Impulse Power Supply

### Best Modes for Carrying Out Invention

Embodiments of the present invention will be described below using the drawings.

### [Embodiment 1]

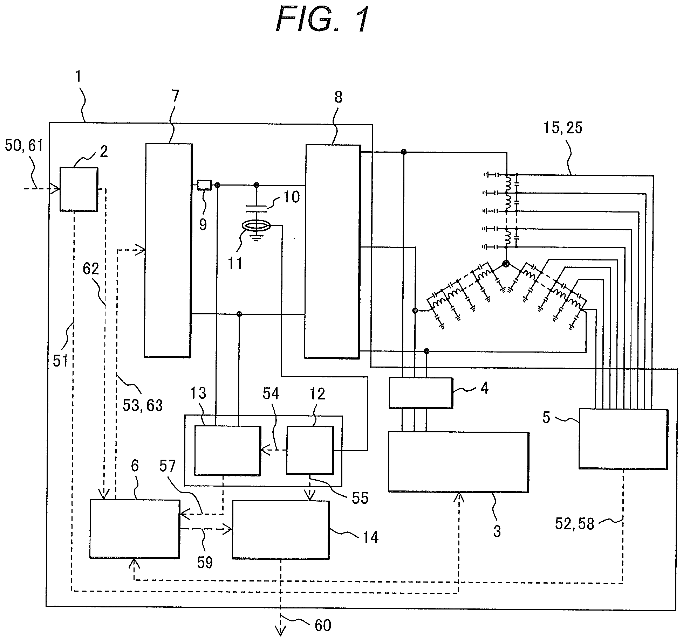

A partial discharge inspection/diagnosis device 1 of an inverter-driven electric rotating machine of Embodiment 1 is shown in FIG. 1.

In the partial discharge inspection/diagnosis device 1, first of all, initial setting of the device is performed using an electric rotating machine 15 for voltage distribution measurement. That is, to start with, by using an input unit 2, a user inputs information 50 such as a model name of the electric rotating machine, a rise time of an inverter surge voltage estimated when the electric rotating machine is inverter-driven, a peak voltage thereof, a pulse width thereof, and a pulse voltage repetition frequency thereof. Information 51 inputted with the input unit is transmitted to a simulated inverter surge voltage power supply (arbitrary waveform generator) 3. At the time when preparation of voltage waveform output from the simulated inverter surge voltage power supply 3 is completed, a UVW 3-phase voltage application switch 4 is closed, and simulated inverter surge voltages are applied to the electric rotating machine 15 for voltage distribution measurement. Voltage waveforms inside the electric rotating machine when the simulated inverter surge voltages are applied, are measured with a voltage wave form measuring unit 5. Measured voltage waveform data 52 is sent to a voltage distribution calculating/recording unit 6. In the voltage distribution calculating/recording unit 6, voltages applied between windings and between different phases inside the electric rotating machine are determined by performing a calculation of difference between the voltage waveforms 52. The determined voltages between the windings and between the different phases are divided by the inputted simulated inverter surge voltages to be converted to an inter-winding voltage sharing ratio α_{inter-winding} and a phase-to-phase voltage sharing ratio αₚₕₐₛₑ₋ₜₒ₋ₚₕₐₛₑ and recorded. At the time when the foregoing measurement ends, the UVW 3-phase voltage application switch 4 is opened.

Next, an impulse voltage output command 53 is issued to an impulse power supply 7. At the time when the preparation of voltage output from the impulse power supply 7 is completed, a UVW 3-phase voltage switching switch 8 is closed and, an impulse test voltage is applied between the U-V phases, between V-W phases, and between W-U phases of the electric rotating machine in succession. The voltage waveforms in the electric rotating machine when the impulse test voltage is applied, are measured with the voltage waveform measuring unit 5. Measured voltage waveform data 58 is sent to the voltage distribution calculating/recording unit 6. In the voltage distribution calculating/recording unit 6, voltages applied between the windings and between the different phases inside the electric rotating machine are determined by performing a calculation of difference between the voltage waveforms 58. The determined voltages between the windings and between the different phases are divided by the inputted impulse test voltage to be converted to an inter-winding voltage sharing ratio β_{inter-winding} and an phase-to-phase voltage sharing ratio βₚₕₐₛₑ₋ₜₒ₋ₚₕₐₛₑ and recorded.

At the time when the initial setting is completed as described above, the electric rotating machine 15 for voltage distribution measurement is replaced with an electric rotating machine under test 25 intended to be subjected to a partial discharge inspection/diagnosis. When information 61 such as the sample number, production date, and the like of the electric rotating machine under test 25 is inputted with the input unit 2 and a test start command 62 is issued. Then, the voltage distribution calculating/recording unit 6 calculates an impulse test voltage by multiplying an inverter surge peak voltage, which is estimated when the electric rotating machine is inverter-driven, by α_{inter-winding}/β_{inter-winding} in an inter-winding test or by αₚₕₐₛₑ₋ₜₒ₋ₚₕₐₛₑ/βₚₕₐₛₑ₋ₜₒ₋ₚₕₐₛₑ in an phase-to phase test, and outputs a test voltage output command 63 to the impulse power supply 7. At the time when the preparation of voltage output from the impulse test power supply is completed, the UVW 3-phase voltage switching switch 8 is closed, and first of all, a partial discharge characteristic of U-V phase is inspected/diagnosed. The partial discharge is measured by using a coupling capacitor 10 disposed between the impulse power supply 7 and the UVW 3-phase voltage switching switch 8 and a partial discharge sensor 11 disposed on the lower voltage side thereof. Note that a protective resistor 9 is provided to suppress an excess current flowing in the impulse power supply 7 or the UVW 3-phase voltage switching switch 8 on the dielectric breakdown of a sample. A partial discharge signal resulting from the measurement using the partial discharge sensor is inputted to a partial discharge measuring instrument 12. The partial discharge measuring instrument 12 transmits a magnitude signal 55 of the measured partial discharge to a display unit, while issuing a command 54 to measure the actual voltage applied to the electric rotating machine at that time to a test voltage measuring instrument 13 at that time. The test voltage measuring instrument 13 measures the test voltage applied to the electric rotating machine, while transmitting impulse test voltage waveform data 57 to the voltage distribution calculating/recording unit 6. The voltage distribution calculating/recording unit 6 divides a peak voltage Vp of the received impulse test voltage wave form by α_{inter-winding}/β_{inter-winding} in an inter-winding test or by αₚₕₐₛₑ₋ₜₒ₋ₚₕₐₛₑ/βₚₕₐₛₑ₋ₜₒ₋ₚₕₐₛₑ in an phase-to-phase test to convert the peak voltage Vp to a voltage equivalent to the inverter surge voltage. A test voltage 59 obtained through the conversion is transmitted to a display unit 14. The user checks from data 60 on the display unit whether or not the voltage has been correctly applied to the sample, while checking whether or not partial discharge of a magnitude over a threshold has occurred, and determines that the electric rotating machine under test 25 is non-acceptable when partial discharge of a magnitude over the threshold has occurred or determines that the electric rotating machine under test 25 is acceptable when the magnitude of a partial discharge measurement signal is not over the threshold. By the same procedure, a V-W phase test and a W-U phase test are also performed.

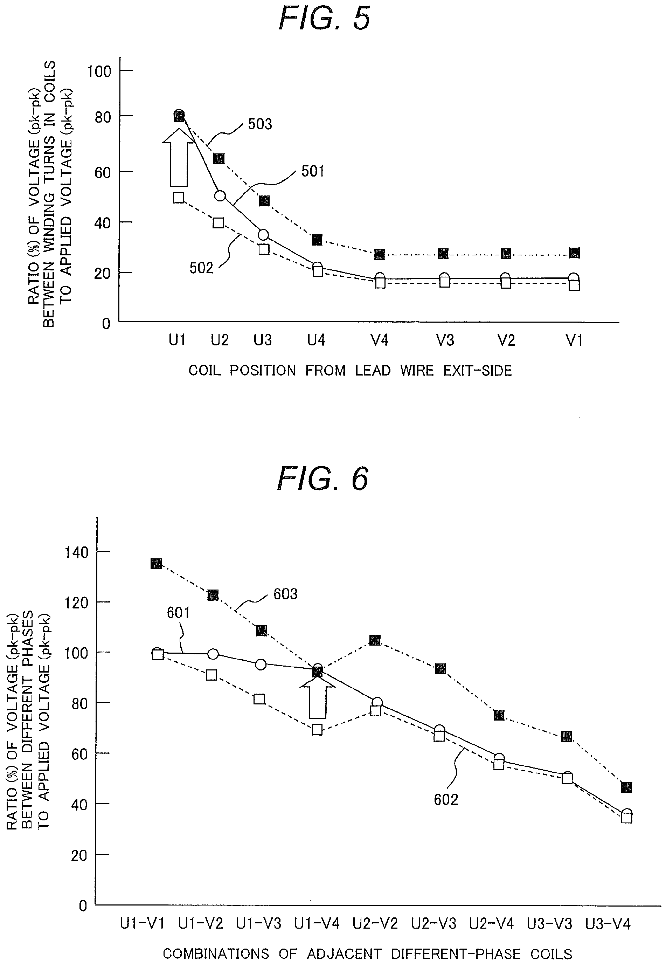

Each of FIGS. 5 and 6 is shown an illustrative view of the function of the present invention. In FIG. 5 are shown ratios between winding turns in the coils of the electric rotating machine when the impulse test voltage and the inverter surge voltage are applied thereto. A voltage distribution α_{inter-winding} when the inverter surge voltage is applied and a voltage distribution β_{inter-winding} when the impulse test voltage is applied, are denoted by 501 and 502, respectively. The numbers following the marks U and V under the abscissa axis show the respective coil numbers of the individual phases at the leadwire exit side. On the application of the inverter surge voltage, a large voltage is distributed to the coil U1. On the application of the impulse voltage also, the same tendency as that of the inverter surge voltage is shown, but the voltage is lower than that when the inverter surge voltage is applied. Accordingly, by merely preparing the impulse power supply having a peak value close to that of the inverter surge voltage applied to the electric rotating machine when the machine is inverter-driven and the same rise time as that of the inverter surge voltage and simply applying the impulse voltage to the electric rotating machine, a sufficient voltage cannot be applied to the coil U1 and the electric rotating machine cannot be correctly inspected. On the other hand, in the present invention, the voltage distributions inside the electric rotating machine are measured in advance and reflected in the test voltage, and therefore the insulation characteristic of the inverter-driven electric rotating machine can be completely inspected/diagnosed.

That is, by determining the ratio α_{inter-winding}/β_{inter-winding} between the voltage distribution α_{inter-winding} in inter-winding of the electric rotating machine when the inverter surge voltage is applied and the voltage distribution β_{inter-winding} in inter-winding thereof when the impulse test voltage is applied, and correcting the impulse test voltage through multiplication by the ratio (Impulse Test Voltage = Inverter Surge Voltage × (α_{inter-winding}/β_{inter-winding})), the inter-winding voltage distribution 502 during the impulse test is increased to a position 503 to be higher than at least the voltage distribution 501 when the inverter surge voltage is applied.

By so doing, after the corrected impulse test voltage is determined, the insulation characteristic inside the inverter-driven electric rotating machine can be completely inspected/diagnosed by using only the impulse test voltage, and whether or not the electric rotating machine can withstand the inverter surge voltage can be correctly evaluated.

FIG. 6 shows voltage ratios between different phases in the electric rotating machine when the impulse test voltage and the inverter surge voltage are applied to the electric rotating machine. A voltage distribution αₚₕₐₛₑ₋ₜₒ₋ₚₕₐₛₑ when the inverter surge voltage is applied and a voltage distribution βₚₕₐₛₑ₋ₜₒ₋ₚₕₐₛₑ when the impulse test voltage is applied are denoted by 601 and 602, respectively. The numbers following the marks U and V under the abscissa axis show the respective coil numbers of the individual phases at the leadwire exit side. On the application of the inverter surge voltage, large voltages are distributed to between the coils U1-V1, U1-V2, U1-V3, and U1-V4. On the application of the impulse voltage also, the same tendency as the inverter surge voltage is shown, but the voltages are lower between the coils U1-V4 than that when the inverter surge voltage is applied. This shows that, by merely preparing the impulse power supply having the same rise time as that of the inverter surge voltage applied to the electric rotating machine when the machine is inverter-driven and simply applying the impulse voltage to the electric rotating machine, a sufficient voltage cannot be applied to the coil U1 and the electric rotating machine cannot be correctly inspected.

On the other hand, in the present invention, the voltage distributions inside the electric rotating machine are measured in advance and reflected in the test voltage, and therefore the insulation characteristic of the inverter-driven electric rotating machine can be completely inspected/diagnosed. That is, by determining the ratio αₚₕₐₛₑ₋ₜₒ₋ₚₕₐₛₑ/βₚₕₐₛₑ₋ₜₒ₋ₚₕₐₛₑ between the voltage distribution αₚₕₐₛₑ₋ₜₒ₋ₚₕₐₛₑ in inter-phase of the electric rotating machine when the inverter surge voltage is applied and the voltage distribution βₚₕₐₛₑ₋ₜₒ₋ₚₕₐₛₑ thereof when the impulse test voltage is applied, and correcting the impulse test voltage through multiplication by the ratio (Impulse Test Voltage = Inverter Surge Voltage × (αₚₕₐₛₑ₋ₜₒ₋ₚₕₐₛₑ/βₚₕₐₛₑ₋ₜₒ₋ₚₕₐₛₑ)), the phase-to-phase voltage distribution 602 during the impulse test is increased to a position 603 to be higher than at least the voltage distribution 601 when the inverter surge voltage is applied. By so doing, after the corrected impulse test voltage is determined, the insulation characteristic inside the inverter-driven electric rotating machine can be completely inspected/diagnosed using only the impulse test voltage, and whether or not the electric rotating machine can withstand the inverter surge voltage can be correctly evaluated.

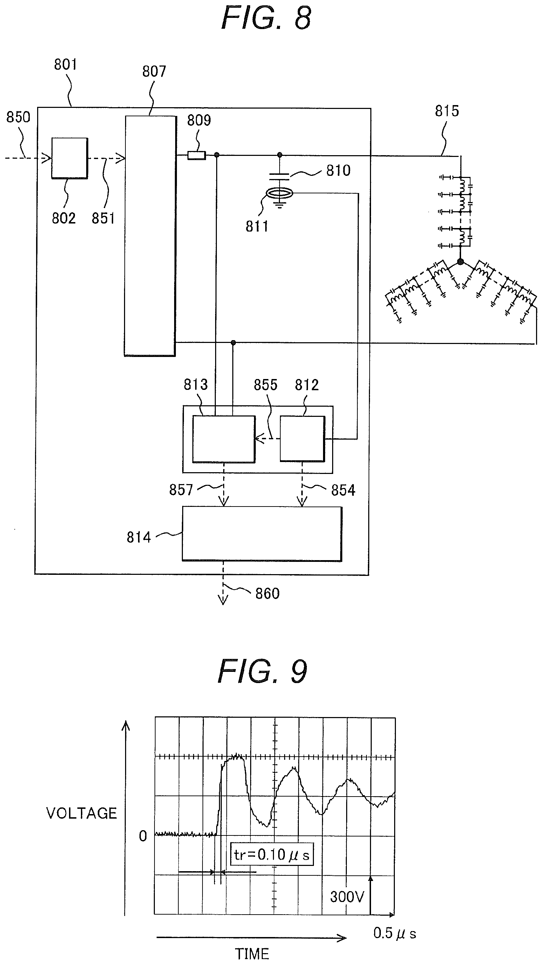

To examine the foregoing voltage distribution difference between the inverter surge voltage and the impulse voltage, the result of measuring an inverter surge voltage waveform is shown in FIG. 9, while the result of measuring an impulse test voltage waveform in Embodiment 1 is shown in FIG. 10. FIG. 11 is an illustrative view showing the entire inverter surge voltage.

The voltage rise time of the inverter voltage waveform of FIG. 9 is 0.1 µs. On the other hand, the rise time of the impulse voltage from the impulse power supply 7 used in Embodiment 1 is 0.1 µs under no load, but is increased up to 0.25 µs when the electric rotating machine is actually connected, as shown in FIG. 10.

This shows that, by merely preparing the impulse power supply having the same rise time as that of the inverter surge voltage applied to the electric rotating machine when the machine is inverter-driven, the impulse voltage having the same rise time as that of the inverter surge voltage cannot necessarily be applied to the electric rotating machine. Also, in the inverter surge voltage waveform, after the voltage rises at 0.1 µs and oscillates, a dc voltage is applied during a given period, and then the voltage steeply falls to the opposite polarity. On the other hand, in the impulse test voltage waveform of FIG. 10, the voltage rises at 0.25 ps, and then, through gentle damped oscillation, the voltage has become 0 V. This shows that, even if the impulse voltage having the same rise time as that of the voltage applied to the electric rotating machine when the machine is inverter-driven can be applied to the electric rotating machine, since the voltage waveforms are originally greatly different from each other, it is not necessarily possible to implement the same voltage distributions inside the electric rotating machine as that when the machine is inverter-driven with the impulse voltage and perform an insulation inspection/diagnosis.

That is, when the electric rotating machine is tested by using the impulse voltage as in the present invention, it maybe assumed that consideration should be given to the internal voltage distributions of the electric rotating machine. If consideration is given to the internal voltage distributions of the electric rotating machine as in the present invention, it may be assumed that the impulse voltage having the same rise time as that of the inverter surge voltage applied to the electric rotating machine when the machine is inverter-driven need not necessarily be used. It may also be assumed that, besides the impulse voltage waveform, various waveforms such as those of a high frequency sine wave, a high frequency damped oscillatory wave (burst wave), and a rectangular wave can used. It may also be assumed that, as polarity, either unipolarity or bipolarity can be used.

### [Embodiment 2]

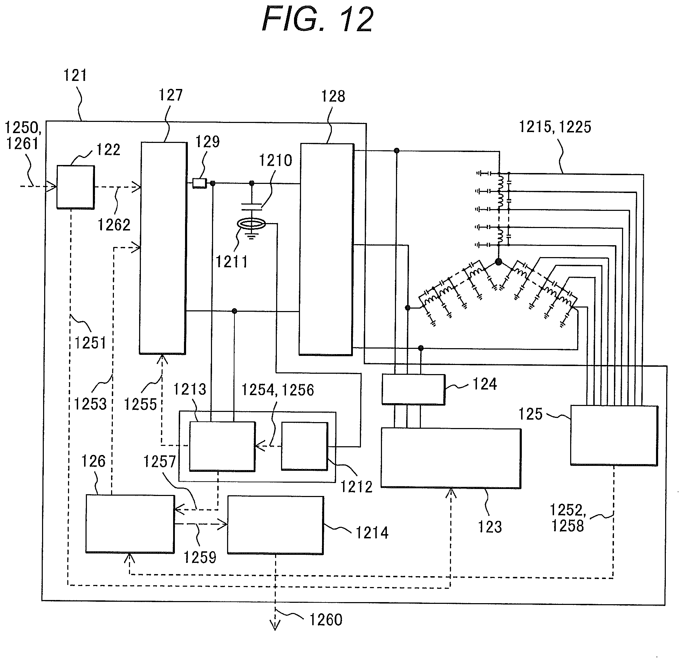

A partial discharge inspection/diagnosis device 121 of an inverter-driven electric rotating machine of Embodiment 2 is shown in FIG. 12.

In Embodiment 1 previously described, it is inspected/diagnosed whether or not, at the inverter surge voltage estimated when the electric rotating machine is inverter-driven, partial discharge over the threshold occurs. The device configuration of Embodiment 2 is substantially the same as that of Embodiment 1 but, in Embodiment 2, a partial discharge start voltage in the electric rotating machine is measured. First of all, in the same manner as in Embodiment 1, initial setting of the device is performed by using an electric rotating machine 1215 for voltage distribution measurement. That is, to start with, using an input unit 122, a user inputs information 1250 such as the model name of the electric rotating machine, a rise time of an inverter surge voltage estimated when the electric rotating machine is inverter-driven, a peak voltage thereof, a pulse width thereof, and a pulse voltage repetition frequency thereof. Information 1251 inputted with the input unit is transmitted to a simulated inverter surge voltage power supply (arbitrary waveform generator) 123. At the time when the preparation of voltage waveform output from the simulated inverter surge voltage power supply 123 is completed, a UVW 3-phase voltage application switch 124 is closed, and simulated inverter surge voltages are applied to the electric rotating machine 1215 for voltage distribution measurement. Voltage waveforms inside the electric rotating machine when simulated inverter surge voltages are applied, are measured with a voltage waveform measuring unit 125. Measured voltage waveform data 1252 is sent to a voltage distribution calculating/recording unit 126. In the voltage distribution calculating/recording unit 126, voltages applied between windings and between different phases inside the electric rotating machine are determined by performing a calculation of difference between the voltage waveforms 1252. The determined voltages between the windings and between the different phases are divided by the inputted simulated inverter surge voltages to be converted to the inter-winding voltage sharing ratio center-winding and the phase-to-phase voltage sharing ratio αₚₕₐₛₑ₋ₜₒ₋ₚₕₐₛₑ and recorded. At the time when the foregoing measurement ends, the UVW 3-phase voltage application switch 124 is opened.

Next, an impulse voltage output command 1253 is issued to an impulse power supply 127. At the time when the preparation of voltage output from the impulse power supply 127 is completed, a UVW 3-phase voltage switching switch 128 is closed and, an impulse test voltage is applied between the U-V phases, between V-W phases, and between W-U phases of the electric rotating machine in succession. The voltage waveforms in the electric rotating machine when the impulse test voltage is applied, are measured with the voltage waveform measuring unit 125. Measured voltage waveform data 1258 is sent to the voltage distribution calculating/recording unit 126. In the voltage distribution calculating/recording unit 126, voltages applied between the windings and between the different phases inside the electric rotating machine are determined by performing a calculation of difference between the voltage waveforms 1258. The determined voltages between the winding and between the different phases are divided by the inputted impulse test voltage to be converted to the inter-winding voltage sharing ratio β_{inter-winding} and the phase-to-phase voltage sharing ratio βₚₕₐₛₑ₋ₜₒ₋ₚₕₐₛₑ and recorded.

At the time when the initial setting is completed as described above, the electric rotating machine 1215 for voltage distribution measurement is replaced with an electric rotating machine under test 1225 intended to be subjected to a partial discharge inspection/diagnosis (which is a partial discharge start voltage diagnosis herein). When information 1261 such as the sample number, production date, and the like of the electric rotating machine under test 1225 is inputted with the input unit 122 and a test start command is issued, the impulse voltage output command 62 is issued to the impulse power supply 7. At the time when the preparation of voltage output from the impulse power supply 7 is completed, the UVW 3-phase voltage switching switch 128 is closed, and first of all, a U-V partial discharge characteristic is inspected/diagnosed. The partial discharge is measured by using a coupling capacitor 1210 disposed between the impulse power supply 127 and the UVW 3-phase voltage switching switch 128 and a partial discharge sensor disposed on the lower voltage side thereof. Note that a protective resistor 129 is provided to suppress an excess current flowing in the impulse power supply 127 or the UVW 3-phase voltage switching switch 128 on the dielectric breakdown of a sample. A partial discharge signal resulting from the measurement using the partial discharge sensor is inputted to a partial discharge measuring instrument 1212. The partial discharge measuring instrument 1212 issues, when the partial discharge signal larger than the partial discharge signal of a predetermined magnitude has not been measured, a voltage boost command 1254 to a test voltage measuring instrument 1213. The test voltage measuring instrument 1213 measures the current test voltage, while calculating a test voltage corresponding to a predetermined increment, and issues a voltage output command 1255 to the impulse power supply 127. The impulse power supply 127 applies the boosted test voltage to the electric rotating machine 1225, and repeats the same voltage boosting step until partial discharge occurs.

When the occurrence of partial discharge in the sample is sensed by a partial discharge sensor 1211 and the partial discharge measuring instrument 1212, the partial discharge measuring instrument 1212 issues a command 1256 to record the current impulse test voltage and lower the test voltage to the test voltage measuring instrument 1213. The test voltage measuring instrument 1213 records the impulse test voltage actually applied to the electric rotating machine, and transmits impulse test voltage waveform data 1257 to the voltage distribution calculating/recording unit 126. The voltage distribution calculating/recording unit 126 divides the peak voltage Vp of the received impulse test voltage waveform by α_{inter-winding}/β_{inter-winding} in an inter-winding test or by αₚₕₐₛₑ₋ₜₒ₋ₚₕₐₛₑ /βₚₕₐₛₑ₋ₜₒ₋ₚₕₐₛₑ in an phase-to-phase test to convert the peak voltage Vp to a voltage equivalent to the inverter surge voltage . A partial discharge start voltage 1259 obtained through the conversion is transmitted to a display unit 1214. The user compares a partial discharge start voltage 1260 on the display unit with the inverter surge voltage estimated when the electric rotating machine is inverter-driven, and determines that the electric rotating machine under test 25 is acceptable when the partial discharge start voltage 1260 is higher than the inverter surge voltage estimated when the electric rotating machine is inverter-driven or determines that the electric rotating machine under test 25 is non-acceptable when the partial discharge start voltage 1260 is lower than the inverter surge voltage estimated when the electric rotating machine is inverter-driven. By the same procedure, a V-W phase test and a W-U phase test are also performed.

In Embodiment 2, the partial discharge start voltage of the electric rotating machine is measured. Therefore, it is possible to measure how much margin the partial discharge start voltage has for the inverter surge voltage estimated when the electric rotating machine is driven with the inverter. In addition, since product-to-product variations in partial discharge start voltage characteristic can be measured, by recognizing the measured variations, it is possible to quantify product manufacturing variations and perform product quality management.

### [Embodiment 3]

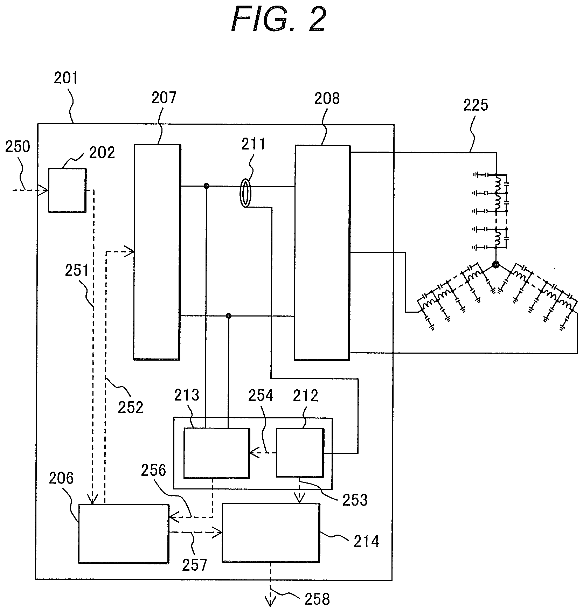

A partial discharge inspection/diagnosis device 201 of an inverter-driven electric rotating machine of Embodiment 3 is shown in FIG. 2.

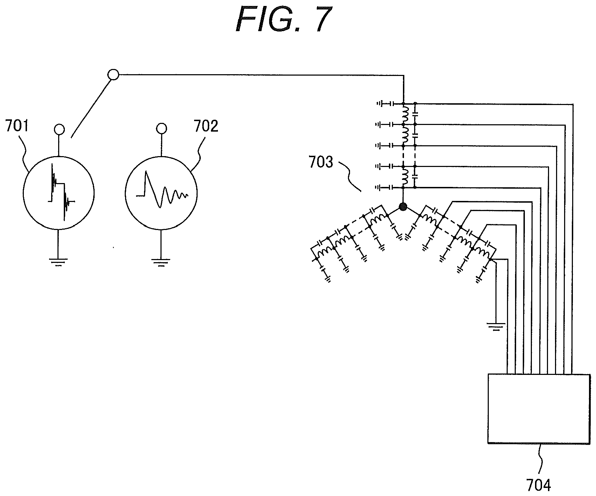

In Embodiment 3, unlike in Embodiments 1 and 2, voltage distributions inside the electric rotating machine when an inverter surge voltage and an impulse voltage are applied and a conversion factor are determined by another calculating device different from the partial discharge inspection/diagnosis device 201, and inputted to the partial discharge inspection/diagnosis device 201. A specific determination method using such another calculating device is shown in FIG. 7.

In FIG. 7, first of all, a simulated inverter surge voltage power supply 701 applies a simulated inverter surge voltage to an electric rotating machine 703 for voltage distribution measurement, wherein the simulated inverter surge voltage has a rise time of the inverter surge voltage estimated when the electric rotating machine is inverter-driven, a peak voltage thereof, a pulse width thereof, and a pulse voltage repetition frequency thereof. In addition, voltage waveforms inside the electric rotating machine at this time are measured with a voltage waveform measuring unit 704. Next, an impulse voltage is applied by using an impulse power supply 702 to the electric rotating machine 703 for voltage distribution measurement. In addition, the voltage waveforms inside the electric rotating machine at this time are measured with the voltage waveform measuring unit 704. The obtained data is converted to an inter-winding voltage and a phase-to-phase voltage with respect to an input voltage, as shown in FIGS. 5 and 6. Calculation is performed as to the respective ratios between the voltage sharing ratios α_{inter-winding}, αₚₕₐₛₑ₋ₜₒ₋ₚₕₐₛₑ and the voltage sharing ratios β_{inter-winding}, βₚₕₐₛₑ₋ₜₒ₋ₚₕₐₛₑ, wherein the voltage sharing ratios α_{inter-winding} and αₚₕₐₛₑ₋ₜₒ₋ₚₕₐₛₑ is measured by using the inverter surge voltage estimated when the electric rotating machine is inverter-driven, and the voltage sharing ratios β_{inter-winding} and βₚₕₐₛₑ₋ₜₒ₋ₚₕₐₛₑ is measured when a test is performed with the impulse voltage. The resulting ratio are designated as test voltage correction factors α_{inter-winding}/β_{inter-winding} and αₚₕₐₛₑ₋ₜₒ₋ₚₕₐₛₑ/βₚₕₐₛₑ₋ₜₒ₋ₚₕₐₛₑ.

Information 250 such as the test voltage correction factors obtained as described above and the inverter surge voltage estimated when the electric rotating machine is inverter-driven, is inputted to the partial discharge inspection/diagnosis device 201 using an input unit 202, as shown in FIG. 2. Inputted data 251 is transmitted to a voltage distribution calculating/recording unit 206.

In the voltage distribution calculating/recording unit 206, an impulse test voltage is calculated by multiplying the inverter surge peak voltage, which is estimated when the electric rotating machine is inverter-driven, by either of these test voltage correction factors, and outputs a test voltage output command 252 to an impulse power supply 207. At the time when the preparation of voltage output from the impulse test power supply is completed, a UVW 3-phase voltage switching switch 208 is closed, and first of all, a U-V partial discharge characteristic is inspected/diagnosed. The partial discharge is measured with a partial discharge sensor 211 which is disposed between the impulse power supply 207 and the UVW 3-phase voltage switching switch 208. Note that, in Embodiment 3, the partial discharge measuring sensor is disposed in a high-voltage line but, partial discharge can be also measured by sensing a current flowing in the line. A partial discharge signal resulting from the measurement using the partial discharge sensor 211 is inputted to a partial discharge measuring instrument 212.

In the partial discharge measuring instrument 212, a magnitude signal 253 of the measured partial discharge is transmitted to a display unit, while a command 254 to measure the actual voltage applied to the electric rotating machine at that time is issued to a test voltage measuring instrument 213. The test voltage measuring instrument 213 measures the test voltage applied to the electric rotating machine, and also transmits impulse test voltage waveform data 256 to the voltage distribution calculating/recording unit 206. The voltage distribution calculating/recording unit 206 divides the peak voltage Vp of the received impulse test voltage waveform by α_{inter-winding}/β_{inter-winding} in an inter-winding test or by αₚₕₐₛₑ₋ₜₒ₋ₚₕₐₛₑ /βₚₕₐₛₑ₋ₜₒ₋ₚₕₐₛₑ in a phase-to-phase test to convert the peak voltage Vp to a voltage equivalent to the inverter surge voltage. A test voltage 257 obtained through the conversion is transmitted to a display unit 214. A user checks whether or not the voltage has been correctly applied to a sample from data 258 on the display unit, while checking whether or not partial discharge of a magnitude over a threshold has occurred. Thereby the user determines that an electric rotating machine under test 225 is non-acceptable when partial discharge of a magnitude over the threshold has occurred or determines that the electric rotating machine under test 225 is acceptable when the magnitude of a partial discharge measurement signal is not over the threshold. By the same procedure, a V-W test and a W-U test are also performed.

### [Embodiment 4]

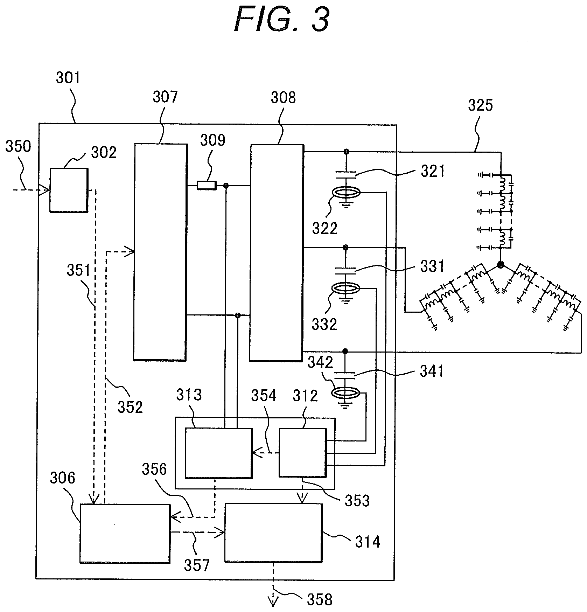

A partial discharge inspection/diagnosis device 301 of an inverter-driven electric rotating machine of Embodiment 4 is shown in FIG. 3.

In Embodiment 4, in the same manner as in Embodiment 3, voltage distributions inside the electric rotating machine when an inverter surge voltage and an impulse voltage are applied and a conversion factor are determined in accordance with the method of FIG. 7. However, in Embodiment 4, a user performs a correction calculation of an impulse test voltage with a correction factor in advance and, by using an input unit 302, inputs the result thereof, together with the correction factor, as input data 350 to the partial discharge inspection/diagnosis device 301.

Inputted data 351 is transmitted to a voltage distribution calculating/recording unit 306. The voltage distribution calculating/recording unit 306 outputs a command 352 to an impulse power supply 307, wherein the command 352 is to output the impulse test voltage of which the correction calculation has been performed in advance by the user. At the time when the preparation of voltage output from the impulse test power supply is completed, a UVW 3-phase voltage switching switch 308 is closed, and first of all, a U-V partial discharge characteristic is inspected/diagnosed. The partial discharge is measured by using coupling capacitors 321, 331, and 341 and partial discharge sensors 322, 332, and 342 which are disposed between the UVW 3-phase voltage switching switch 308 and an electric rotating machine under test 325. Note that, in Embodiment 4, the partial discharge measuring sensors are provided for the individual phases in one-to-one correspondence. By thus providing the partial discharge sensors at positions close to the terminals of the electric rotating machine, partial discharge can be measured with high sensitivity. In a partial discharge measuring instrument 312, a magnitude signal 353 of the measured partial discharge is transmitted to a display unit, while a command 354 to measure the actual voltage applied to the electric rotating machine at that time is issued to a test voltage measuring instrument 313. The test voltage measuring instrument 313 measures the test voltage applied to the electric rotating machine, and also transmits impulse test voltage waveform data 356 to the voltage distribution calculating/recording unit 306.

The voltage distribution calculating/recording unit 306 divides the peak voltage Vp of the received impulse test voltage waveform by α_{inter-winding}/β_{inter-winding} in an inter-winding test or by αₚₕₐₛₑ₋ₜₒ₋ₚₕₐₛₑ/βₚₕₐₛₑ₋ₜₒ₋ₚₕₐₛₑ in a phase-to-phase test to convert the peak voltage Vp to a voltage equivalent to the inverter surge voltage. A test voltage 357 obtained through the conversion is transmitted to a display unit 314. The user checks whether or not the voltage has been correctly applied to a sample from data 358 on the display unit, while checking whether or not partial discharge of a magnitude over a threshold has occurred. Thereby, the user determines that an electric rotating machine under test 325 is non-acceptable when partial discharge of a magnitude over the threshold has occurred or determines that the electric rotating machine under test 325 is acceptable when the magnitude of a partial discharge measurement signal is not over the threshold. By the same procedure, a V-W test and a W-U test are also performed.

### [Embodiment 5]

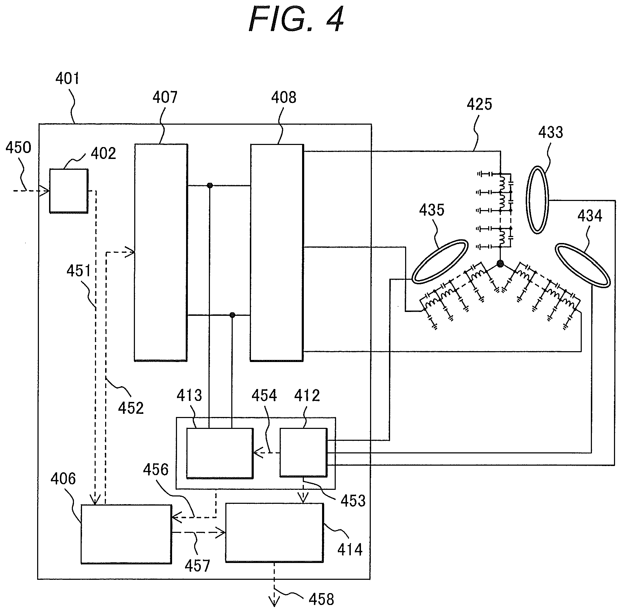

A partial discharge inspection/diagnosis device 401 of an inverter-driven electric rotating machine of Embodiment 5 is shown in FIG. 4.

In Embodiment 5, in the same manner as in Embodiments 3 and 4, voltage distributions inside the electric rotating machine when an inverter surge voltage and an impulse voltage are applied and a conversion factor are determined in accordance with the method of FIG. 7.

In Embodiment 5, in the same manner as in Embodiment 4, a user performs a correction calculation of an impulse test voltage with a correction factor in advance and, by using an input unit 402, inputs the result thereof, together with the correction factor, as input data 450 to the partial discharge inspection/diagnosis device 401. Inputted data 451 is transmitted to a voltage distribution calculating/recording unit 406. The voltage distribution calculating/recording unit 406 outputs a command 452 to an impulse power supply 407, wherein the command 452 is to output the impulse test voltage of which the correction operation has been performed in advance by the user. At the time when the preparation of voltage output from the impulse test power supply is completed, a UVW 3-phase voltage switching switch 408 is closed, and first of all, a U-V partial discharge characteristic is inspected/diagnosed. The partial discharge is measured by using partial discharge sensors 433, 434, and 435 disposed around an electric rotating machine under test 425.

Note that, in Embodiment 5, the partial discharge measuring sensors are provided around the electric rotating machine. By thus providing the partial discharge sensors at positions close to the electric rotating machine, partial discharge can be measured with high sensitivity. In addition, in the case of using sensors and an antenna each having directionality, a generation source (coil) of partial discharge can be specified by disposing the sensors in the vicinity of coils where a shared voltage is in high or by making the antenna movable in the vicinity thereof, in consideration of voltage distributions measured in advance.

In a partial discharge measuring instrument 412, a magnitude signal 453 of the measured partial discharge is transmitted to a display unit, while a command 454 to measure the actual voltage applied to the electric rotating machine at that time is issued to a test voltage measuring instrument 413. The test voltage measuring instrument 413 measures the test voltage applied to the electric rotating machine, and also transmits impulse test voltage waveform data 456 to the voltage distribution calculating/recording unit 406.

The voltage distribution calculating/recording unit 406 divides the peak voltage Vp of the received impulse test voltage waveform by α_{inter-winding}/β_{inter-winding} in an inter-winding test or by αₚₕₐₛₑ₋ₜₒ₋ₚₕₐₛₑ/βₚₕₐₛₑ₋ₜₒ₋ₚₕₐₛₑ in a phase-to-phase test to convert the peak voltage Vp to a voltage equivalent to the inverter surge voltage. A test voltage 457 obtained through the conversion is transmitted to a display unit 414. The user checks whether or not the voltage has been correctly applied to a sample from data 458 on the display unit, while checking whether or not partial discharge of a magnitude over a threshold has occurred. Thereby the user determines that the electric rotating machine under test 325 is non-acceptable when partial discharge of a magnitude over the threshold has occurred or determines that the electric rotating machine under test 325 is acceptable when the magnitude of a partial discharge measurement signal is not over the threshold. By the same procedure, a V-W test and a W-U test are also performed.

### [Comparative Embodiment 1]

A conventional partial discharge inspection/diagnosis device 801 for an inverter-driven electric rotating machine is shown in FIG. 8.

In the conventional partial discharge inspection/diagnosis device 801, an inverter surge peak voltage estimated when an electric rotating machine is inverter-driven, is inputted as input data 850 to the partial discharge inspection/diagnosis device 801 by using an input unit 802. Inputted data 851 is transmitted as a command value to an impulse power supply 807. Partial discharge is measured by using a coupling capacitor 810 disposed between the impulse power supply 807 and an electric rotating machine under test 815 and a partial discharge sensor 811 disposed on the lower-voltage side thereof.

Note that a protective resistor 809 is provided to suppress an excess current flowing in the impulse power supply 807 on the dielectric breakdown of a sample. A partial discharge measuring instrument 812 transmits a magnitude signal 854 of the measured partial discharge to a display unit, while issuing a command 855 to measure the actual voltage applied to the electric rotating machine at that time to a test voltage measuring instrument 813. The test voltage measuring instrument 813 measures the test voltage applied to the electric rotating machine, and also transmits it directly to a display unit 814. A user checks from data 860 on the display unit whether or not an impulse voltage has been applied to the sample, while checking whether or not partial discharge of a magnitude over a threshold has occurred. Thereby the user determines that the electric rotating machine under test 815 is non-acceptable when partial discharge of a magnitude over the threshold value has occurred or determines that the electric rotating machine under test 815 is acceptable when the magnitude of a partial discharge measurement signal is not over the threshold. By the same procedure, a V-W test and a W-U test are also performed. According to the conventional method, the user only finds that the voltage has been correctly applied to the electric rotating machine under test, and cannot recognize what kind of voltage could be applied to the interior of the electric rotating machine . Therefore, even if, e.g., partial discharge of a magnitude over the threshold voltage has not occurred in the data 860 on the display unit, it cannot be determined whether or not the electric rotating machine under test 815 could be correctly inspected/diagnosed or whether or not a problem occurs when the electric rotating machine under test is actually inverter-driven.

## Claims

1. An insulation inspection/diagnosis method for an electric rotating machine (15), comprising the steps of:
calculating a ratio between a shared voltage inside the electric rotating machine (15) at an inverter surge voltage and a shared voltage inside the electric rotating machine (15) at a test voltage for inspecting the electric rotating machine (15), the test voltage being formed of any one of an impulse voltage, a rectangular wave voltage, a high frequency sine wave voltage, and a high frequency damped oscillatory wave voltage; and
using the ratio to correct the test voltage.

2. The insulation inspection/diagnosis method according to claim 1, further comprising the steps of:
preparing the electric rotating machine (15) used for voltage distribution measurement provided with a terminal for measuring a voltage distribution in windings;
applying the inverter surge voltage or the voltage simulating the inverter surge voltage to the electric rotating machine (15) to measure voltage distributions between windings and between different phases inside the electric rotating machine (15);
preparing an inspection power supply (7) used for an inspection/diagnosis test of the electric rotating machine (15) ;
applying the test voltage produced in the inspection power supply to the electric rotating machine (15) to measure voltage distributions between the windings and between the different phases inside the electric rotating machine (15); and
comparing respective measurement values of these voltage distributions with each other to determine the ratio between the two shared voltages and determining a correction factor for the test voltage from the ratio between the two shared voltages.

3. The insulation inspection/diagnosis method according to claim 1, further comprising the steps of:
determining a test voltage correction factor from the ratio;
correcting a magnitude of the test voltage by using the test voltage correction factor; and
by using the corrected test voltage, performing inspection/diagnosis for at least one of a withstand-voltage characteristic showing an insulation characteristic of an inverter-driven electric rotating machine (15) and the presence or absence of partial discharge.

4. The insulation inspection/diagnosis method according to claim 1, further comprising the step of:
when applying the test voltage to the electric rotating machine (15),
converting or inverse-converting an insulation characteristic of the electric rotating machine (15) with respect to the test voltage into an insulation characteristic thereof at the inverter surge voltage.

5. The insulation inspection/diagnosis method according to claim 1, further comprising the steps of:
when applying the test voltage to the electric rotating machine (15),
determining an insulation characteristic of the electric rotating machine (15) with respect to the test voltage;
converting the insulation characteristic of the electric rotating machine (15) with respect to the test voltage into an insulation characteristic thereof at the inverter surge voltage with a test voltage correction factor being determined from the ratio; and
thereby obtaining at least one of a partial discharge start voltage serving as an indicator of an inverter surge withstand voltage of the electric rotating machine (15) and a dielectric breakdown voltage.

6. An insulation inspection/diagnosis device for an electric rotating machine (15), comprising:
an arbitrary waveform generator (3) for simulating an inverter surge voltage applied to the electric rotating machine (15); and
a test voltage generator (7) for generating a test voltage for inspecting the electric rotating machine (15), the test voltage being formed of any one of an impulse voltage, a rectangular wave voltage, a high frequency sine wave voltage, and a high frequency damped oscillatory wave voltage, and
a storing means (6) for storing therein at least one of a ratio between a shared voltage inside the electric rotating machine (15) at the inverter surge voltage and a shared voltage inside the electric rotating machine (15) at the test voltage, said ratio is designated as a correction factor for the test voltage.

7. The insulation inspection/diagnosis device according to claim 6, which is configured to receive at least one of the shared voltage inside the electric rotating machine (15) at the inverter surge voltage as well as the shared voltage inside the electric rotating machine (15) at the test voltage, and the test voltage correction factor determined from the ratio between the two shared voltages.

8. The insulation inspection/diagnosis method according to claim 1, further comprising the step of:
performing inspection/diagnosis of an insulation characteristic defective portion in the electric rotating machine (425) and an insulation characteristic of the portion, by using the ratio, a voltage distribution inside the electric rotating machine (425) at the test voltage; and an antenna (433, 434, 435) for measuring an electromagnetic wave resulting from partial discharge.

9. The insulation inspection/diagnosis device according to claim 6, comprising:
a means for determining a shared voltage inside the electric rotating machine at an inverter surge voltage;
a means for determining a shared voltage inside the electric rotating machine at the test voltage;
a means for determining a voltage distribution inside the electric rotating machine (425) at the test voltage;
an antenna (433, 434, 435) for measuring an electromagnetic wave resulting from partial discharge; and
a means (401) for performing inspection/diagnosis of an insulation characteristic defective portion of the electric rotating machine and an insulation characteristic of the portion by using the ratio, the voltage distribution inside the electric rotating machine (425) at the test voltage, and the electromagnetic wave resulting from the partial discharge measured by the antenna (433, 434, 435).

## Patentansprüche

1. Isolationsprüfungs-/Diagnoseverfahren für eine elektrische rotierende Maschine (15), umfassend die Schritte von:
Berechnen eines Verhältnisses zwischen einer gemeinsamen Spannung innerhalb der elektrischen rotierenden Maschine (15) bei einer Wechselrichterstoßspannung und einer gemeinsamen Spannung innerhalb der elektrischen rotierenden Maschine (15) bei einer Prüfspannung zum Prüfen der elektrischen rotierenden Maschine (15), wobei die Prüfspannung aus einer beliebigen Impulsspannung, einer Rechteckwellenspannung, einer Hochfrequenz-Sinusspannung und einer Spannung mit Hochfrequenz-gedämpfter Schwingung gebildet ist; und
Verwenden des Verhältnisses zum Korrigieren der Prüfspannung.

2. Isolationsprüfungs-/Diagnoseverfahren nach Anspruch 1, ferner umfassend die Schritte von:
Vorbereiten der elektrischen rotierenden Maschine (15), die zur Messung der Spannungsverteilung verwendet wird, die mit einem Anschluss zum Messen einer Spannungsverteilung in Wicklungen versehen ist;
Anlegen der Wechselrichterstoßspannung oder der Spannung, welche die Wechselrichterstoßspannung simuliert, an die elektrische rotierende Maschine (15), um Spannungsverteilungen zwischen Wicklungen und zwischen verschiedenen Phasen innerhalb der elektrischen rotierenden Maschine (15) zu messen;
Vorbereiten einer Prüfstromversorgung (7), die für eine Inspektions-/Diagnoseprüfung der elektrischen rotierenden Maschine (15) verwendet wird;
Anlegen der in der Prüfstromversorgung erzeugten Prüfspannung an die elektrische rotierende Maschine (15) zum Messen von Spannungsverteilungen zwischen den Wicklungen und zwischen den verschiedenen Phasen innerhalb der elektrischen rotierenden Maschine (15); und
Vergleichen der jeweiligen Messwerte dieser Spannungsverteilungen miteinander, um das Verhältnis zwischen den beiden gemeinsamen Spannungen zu bestimmen und einen Korrekturfaktor für die Prüfspannung aus dem Verhältnis zwischen den beiden gemeinsamen Spannungen zu bestimmen.

3. Isolationsprüfungs-/Diagnoseverfahren nach Anspruch 1, ferner umfassend die Schritte von:
Bestimmen eines Prüfspannungskorrekturfaktors aus dem Verhältnis;
Korrigieren einer Größe der Prüfspannung unter Verwendung des Prüfspannungskorrekturfaktors; und
Durchführen einer Inspektion/Diagnose, unter Verwendung der korrigierten Prüfspannung, für mindestens eine der Stehspannungscharakteristiken, die eine Isolationscharakteristik von einer Wechselrichter getriebenen elektrischen rotierenden Maschine (15) und das Vorhandensein oder Fehlen einer Teilentladung aufweisen.

4. Isolationsprüfungs-/Diagnoseverfahren nach Anspruch 1, ferner umfassend den Schritt von:
beim Anlegen der Prüfspannung an die elektrisch rotierende Maschine (15),
Umwandeln oder inverses Umwandeln einer Isolationscharakteristik der elektrischen rotierenden Maschine (15) in Bezug auf die Prüfspannung in eine Isolationscharakteristik derselben bei der Wechselrichterstoßspannung.

5. Isolationsprüfungs-/Diagnoseverfahren nach Anspruch 1, ferner umfassend die Schritte von:
beim Anlegen der Prüfspannung an die elektrisch rotierende Maschine (15),
Bestimmen einer Isolationscharakteristik der elektrisch rotierenden Maschine (15) in Bezug auf die Prüfspannung;
Umwandeln der Isolationscharakteristik der elektrisch rotierenden Maschine (15) in Bezug auf die Prüfspannung in eine Isolationscharakteristik derselben bei der Wechselrichterstoßspannung, wobei aus dem Verhältnis ein Prüfspannungskorrekturfaktor bestimmt wird; und
wodurch mindestens eine von einer Teilentladungs-Startspannung, die als Indikator für eine Wechselrichterstoßspannung der elektrischen rotierenden Maschine (15) dient, und einer dielektrischen Durchbruchspannung erhalten wird.

6. Isolationsprüf-/Diagnosevorrichtung für eine elektrische rotierende Maschine (15), umfassend:
einen Arbitrary-Waveform-Generator (3) zum Simulieren einer an die elektrische rotierende Maschine (15) angelegten Wechselrichterstoßspannung; und
einen Prüfspannungsgenerator (7) zum Erzeugen einer Prüfspannung zum Prüfen der elektrischen rotierenden Maschine (15), wobei die Prüfspannung aus einer beliebigen Impulsspannung, einer Rechteckwellenspannung, einer Hochfrequenz-Sinusspannung und einer Spannung mit Hochfrequenz-gedämpfter Schwingung gebildet ist, und
ein Speichermittel (6) zum Speichern darin von mindestens einem von einem Verhältnis zwischen einer gemeinsamen Spannung innerhalb der elektrischen rotierenden Maschine (15) bei der Wechselrichterstoßspannung und einer gemeinsamen Spannung innerhalb der elektrischen rotierenden Maschine (15) bei der Prüfspannung, wobei das Verhältnis als Korrekturfaktor für die Prüfspannung bezeichnet wird.

7. Isolationsprüf-/Diagnosevorrichtung nach Anspruch 6, die konfiguriert ist, um mindestens eine von der gemeinsamen Spannung innerhalb der elektrischen rotierenden Maschine (15) bei der Wechselrichterstoßspannung sowie die gemeinsame Spannung innerhalb der elektrischen rotierenden Maschine (15) bei der Prüfspannung und den aus dem Verhältnis zwischen den beiden gemeinsamen Spannungen bestimmten Prüfspannungskorrekturfaktor zu empfangen.

8. Isolationsprüf-/Diagnoseverfahren nach Anspruch 1, ferner umfassend den Schritt von:
Durchführen einer Inspektion/Diagnose eines Isolationscharakteristik-fehlerhaften Teils in der elektrischen rotierenden Maschine (425) und einer Isolationscharakteristik des Teils, unter Verwendung des Verhältnisses, einer Spannungsverteilung innerhalb der elektrischen rotierenden Maschine (425) bei der Prüfspannung; und einer Antenne (433, 434, 435) zum Messen einer elektromagnetischen Welle, die aus einer Teilentladung resultiert.

9. Isolationsprüf-/Diagnosevorrichtung nach Anspruch 6, umfassend:
ein Mittel zum Bestimmen einer gemeinsamen Spannung innerhalb der elektrischen rotierenden Maschine bei einer Wechselrichterstoßspannung;
ein Mittel zum Bestimmen einer gemeinsamen Spannung innerhalb der elektrischen rotierenden Maschine bei der Prüfspannung;
ein Mittel zum Bestimmen einer Spannungsverteilung innerhalb der elektrischen rotierenden Maschine (425) bei der Prüfspannung;
eine Antenne (433, 434, 435) zum Messen einer elektromagnetischen Welle, die aus einer Teilentladung resultiert; und
ein Mittel (401) zum Durchführen einer Inspektion/Diagnose eines Isolationscharakteristik-fehlerhaften Teils der elektrischen rotierenden Maschine (425) und einer Isolationscharakteristik des Teils unter Verwendung des Verhältnisses, der Spannungsverteilung innerhalb der elektrischen rotierenden Maschine (425) bei der Prüfspannung; und der elektromagnetischen Welle, die aus der Teilentladung resultiert, gemessen durch die Antenne (433, 434, 435).

## Revendications

1. Procédé de contrôle/diagnostic d'isolation pour une machine électrique tournante (15), comprenant les étapes de :
calcul d'un rapport entre une tension partagée à l'intérieur de la machine électrique tournante (15) à une surtension d'onduleur et une tension partagée à l'intérieur de la machine électrique tournante (15) à une tension d'essai pour contrôler la machine électrique tournante (15), la tension d'essai étant formée par l'une quelconque parmi une tension impulsionnelle, une tension à onde rectangulaire, une tension à onde sinusoïdale à haute fréquence, et une tension à onde oscillatoire amortie à haute fréquence ; et
d'utilisation du rapport pour corriger la tension d'essai.

2. Procédé de contrôle/diagnostic d'isolation selon la revendication 1, comprenant en outre les étapes de :
préparation de la machine électrique tournante (15) utilisée pour une mesure de répartition de tension dotée d'un terminal pour mesurer une répartition de tension dans des enroulements ;
application de la surtension d'onduleur ou de la tension simulant la surtension d'onduleur à la machine électrique tournante (15) pour mesurer des répartitions de tension entre enroulements et entre différentes phases à l'intérieur de la machine électrique tournante (15) ;
préparation d'une alimentation d'énergie de contrôle (7) utilisée pour un test de contrôle/diagnostic de la machine électrique tournante (15) ;
application de la tension d'essai produite dans l'alimentation d'énergie de contrôle à la machine électrique tournante (15) pour mesurer des répartitions de tension entre les enroulements et entre les différentes phases à l'intérieur de la machine électrique tournante (15) ; et
de comparaison des valeurs de mesure respectives de ces répartitions de tension les unes avec les autres pour déterminer le rapport entre les deux tensions partagées et déterminer un facteur de correction pour la tension d'essai d'après le rapport entre les deux tensions partagées.

3. Procédé de contrôle/diagnostic d'isolation selon la revendication 1, comprenant en outre les étapes de :
détermination d'un facteur de correction de tension d'essai d'après le rapport ;
correction d'une magnitude de la tension d'essai en utilisant le facteur de correction de tension d'essai ; et
en utilisant la tension d'essai corrigée, de réalisation d'un contrôle/diagnostic pour au moins l'une parmi une caractéristique de tension de tenue montrant une caractéristique d'isolation d'une machine électrique tournante (15) commandée par onduleur et la présence ou l'absence d'une décharge partielle.

4. Procédé de contrôle/diagnostic d'isolation selon la revendication 1, comprenant en outre l'étape de :
lors de l'application de la tension d'essai à la machine électrique tournante (15),
conversion ou conversion inverse d'une caractéristique d'isolation de la machine électrique tournante (15) par rapport à la tension d'essai en une caractéristique d'isolation de celle-ci à la surtension d'onduleur.

5. Procédé de contrôle/diagnostic d'isolation selon la revendication 1, comprenant en outre les étapes de :
lors de l'application de la tension d'essai à la machine électrique tournante (15),
détermination d'une caractéristique d'isolation de la machine électrique tournante (15) par rapport à la tension d'essai ;
conversion de la caractéristique d'isolation de la machine électrique tournante (15) par rapport à la tension d'essai en une caractéristique d'isolation de celle-ci à la surtension d'onduleur avec un facteur de correction de tension d'essai déterminé d'après le rapport ; et
en obtenant de la sorte au moins l'une parmi une tension d'allumage de décharge partielle servant d'indicateur d'une tension de tenue aux surtensions d'onduleur de la machine électrique tournante (15) et une tension de rupture diélectrique.

6. Dispositif de contrôle/diagnostic d'isolation pour une machine électrique tournante (15), comprenant :
un générateur de formes d'ondes arbitraires (3) pour simuler une surtension d'onduleur appliquée à la machine électrique tournante (15) ; et
un générateur de tension d'essai (7) pour générer une tension d'essai pour contrôler la machine électrique tournante (15), la tension d'essai étant formée par l'une quelconque parmi une tension impulsionnelle, une tension à onde rectangulaire, une tension à onde sinusoïdale à haute fréquence, et une tension à onde oscillatoire amortie à haute fréquence, et
un moyen de stockage (6) pour y stocker au moins l'un parmi un rapport entre une tension partagée à l'intérieur de la machine électrique tournante (15) à la surtension d'onduleur et une tension partagée à l'intérieur de la machine électrique tournante (15) à la tension d'essai, ledit rapport étant désigné en tant qu'un facteur de correction pour la tension d'essai.

7. Dispositif de contrôle/diagnostic d'isolation selon la revendication 6, lequel est configuré pour recevoir au moins l'une parmi la tension partagée à l'intérieur de la machine électrique tournante (15) à la surtension d'onduleur ainsi que la tension partagée à l'intérieur de la machine électrique tournante (15) à la tension d'essai, et le facteur de correction de tension d'essai déterminé d'après le rapport entre les deux tensions partagées.

8. Procédé de contrôle/diagnostic d'isolation selon la revendication 1, comprenant en outre l'étape de :
réalisation d'un contrôle/diagnostic d'une partie à caractéristique d'isolation défectueuse dans la machine électrique tournante (425) et d'une caractéristique d'isolation de la partie en utilisant le rapport, une répartition de tension à l'intérieur de la machine électrique tournante (425) à la tension d'essai ; et une antenne (433, 434, 435) pour mesurer une onde électromagnétique résultant d'une décharge partielle.

9. Dispositif de contrôle/diagnostic d'isolation selon la revendication 6, comprenant :
un moyen pour déterminer une tension partagée à l'intérieur de la machine électrique tournante à une surtension d'onduleur ;
un moyen pour déterminer une tension partagée à l'intérieur de la machine électrique tournante à la tension d'essai ;
un moyen pour déterminer une répartition de tension à l'intérieur de la machine électrique tournante (425) à la tension d'essai ;
une antenne (433, 434, 435) pour mesurer une onde électromagnétique résultant d'une décharge partielle ; et
un moyen (401) pour réaliser un contrôle/diagnostic d'une partie à caractéristique d'isolation défectueuse de la machine électrique tournante et d'une caractéristique d'isolation de la partie en utilisant le rapport, la répartition de tension à l'intérieur de la machine électrique tournante (425) à la tension d'essai, et l'onde électromagnétique résultant de la décharge partielle mesurée par l'antenne (433, 434, 435).
